(19) Europäisches Patentamt
European Patent Office
Office européen des brevets

(11) Veröffentlichungsnummer: **0 446 442 A1**

(12) # EUROPÄISCHE PATENTANMELDUNG

(21) Anmeldenummer: **90123538.2**

(51) Int. Cl.5: **H05K 3/38**, C23C 14/02

(22) Anmeldetag: **07.12.90**

(30) Priorität: **16.03.90 DE 4008462**

(43) Veröffentlichungstag der Anmeldung:
**18.09.91 Patentblatt 91/38**

(84) Benannte Vertragsstaaten:
**DE ES FR GB IT**

(71) Anmelder: **BAYER AG**
**W-5090 Leverkusen 1 Bayerwerk(DE)**

(72) Erfinder: **Wolf, Udo, Dr.**
**Uerdinger Strasse 469**
**W-4150 Krefeld 1(DE)**
Erfinder: **Weymans, Günther, Dr.**
**Körnerstrasse 5**
**W-5090 Leverkusen 1(DE)**

(54) **Polyarylensulfid-Leiterplatten mit guter Metallhaftung.**

(57) Die Erfindung betrifft ein Verfahren zur Herstellung von Leiterplatten aus Polyarylensulfid-haltigen Formmassen durch eine spezielle Oberflächenbehandlung mit organischen Lösungsmitteln sowie die Leiterplatten nach diesem Verfahren und ihre Verwendung.

EP 0 446 442 A1

Die Erfindung betrifft ein Verfahren zur Herstellung von Leiterplatten aus Polyarylensulfid-haltigen Formmassen durch eine spezielle Oberflächenbehandlung mit organischen Lösungsmitteln sowie die Leiterplatten nach diesem Verfahren und ihre Verwendung.

Die Erfindung betrifft ein Verfahren zur Herstellung von Leiterplatten aus Polyarylensulfid-haltigen Formmassen. Die hergestellten Leiterplatten zeigen eine sehr gute Haftung des Metalls.

Verfahren zur Verbesserung der Metallhaftung sind bekannt. Diese sind aufwendig und liefern Leiterplatten mit nicht ganz befriedigenden Eigenschaften (z.B. hoher Elektrolytgehalt).

Aus der JP-A 62/142 786 ist die Behandlung von PAS-Formmassen mit HF-Salzen oder HF-haltigen Säuren bekannt. Die so hergestellten Leiterplatten zeigen einen relativ hohen Gehalt an Elektrolyten.

Aus der EP-A 182 379 ist bekannt, durch Laserbehandlung von PAS-Oberflächen und Ionenätzung eine verbesserte Metallhaftung zu erhalten, wenn man bekannte Additive wie $TiO_2$, $SiO_2$, $CaCO_3$ und/oder $CaSO_4$ verwendet. Das Verfahren ist sehr aufwendig.

Aus der US-A 4 486 463 ist bekannt, die Haftung von Kupfer auf PAS-Formmassen zu verbessern, wenn man amorphe Oberflächen z.B. mit Schwefelsäure, Natriumdichromat-Lösungen behandelt. Die Entfernung der verbleibenden Restlösungsmittel auf den PAS-Oberflächen ist problematisch.

Aus der EP-A 103 149 ist bekannt durch physikalische Alterung der PAS-Oberfläche eine verbesserte Metallhaftung zu erreichen. Nachteilig sind hier die langen Zykluszeiten (mehr als 10 Tage) und die nicht immer befriedigende Haftung.

Aus der JP-A 57/187 327 ist bekannt, PAS-Oberflächen (bevorzugt Folienoberflächen) durch Corona-Entladung oder Plasmabehandlung ihre Haftungseigenschaften gegenüber Metallen zu verbessern. Das Verfahren ist aufwendig, die erzielbare Metallhaftung für Leiterplatten nicht befriedigend.

Es wurde nun gefunden, daß man aus Polyarylensulfid-Formmassen Leiterplatten mit guter Metallhaftung herstellen kann, wenn die Oberfläche der nach üblichen bekannten Verfahren (z.B. Extrusion) hergestellten Platte mit aprotischen, organischen Flüssigkeiten behandelt wird.

Die Erfindung betrifft ein Verfahren zur Herstellung von Leiterplatten aus Polyarylensulfid-haltigen Formmassen, dadurch gekennzeichnet, daß Leiterplatten aus einer Polyarylensulfid-haltigen Formmasse mit im wesentlichen amorpher Oberfläche mit aprotischen organischen Flüssigkeiten, bei Temperaturen von 10 °C bis der Glastemperatur der verwendeten Polyarylsulfid-Formmasse, gegebenenfalls nach Aufbringen eines reversiblen Maskennegativs auf die mit Metall zu kontaktierende Leiterplatten-Oberfläche, behandelt werden und dann durch Bedampfen mit den entsprechenden Metallatomen nach bekannten Verfahren metallisiert wird.

Erfindungsgemäß geeignete Polyarylensulfide, (vorzugsweise Polyphenylensulfid (PPS)) sind bekannt (z.B. US-A 3 354 129, EP-A 171 021, EP-A 96 384, EP-A 104 560, DE-A 3 524 471, EP-A 242 617, 265 524, JP-A 62 220 522, DE-A 2 623 362, DE-A 2 623 363). Sie enthalten im allgemeinen Strukturelemente der Formeln

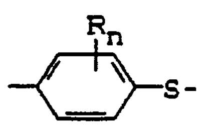
(I),

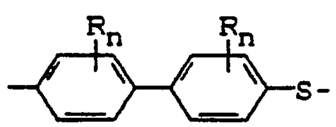
(II),

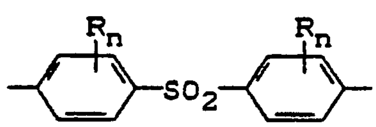
(III),

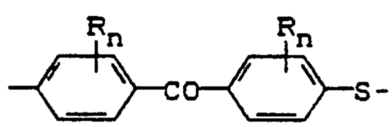
(IV),

in denen

R für $C_1$-$C_4$-Alkyl, $C_6$-$C_{24}$-Aryl und

n für 0, 1, 2,

steht.

Sie können linear oder verzweigt sein. Sie können gegebenenfalls spezielle Endgruppen tragen. Gemische in beliebiger Zusammensetzung der unterschiedlichen PAS sind ebenfalls verwendbar.

Diesen PAS können bekannte Additive, Füllstoffe und Verstärkungsmittel wie z.B. Glasfasern in bekannten Mengen nach bekannten Verfahren zugegeben werden. Auch kleine Bemischungen anderer Polymerer als der PAS- und zwar bevorzugt bis zu maximal 5 Gewichtsteile auf 100 Gewichtsteile PAS -können den PAS-haltigen Formmassen zugegeben werden.

PAS-haltige Formmassen sind bekannt. Geeignet sind z.B. die unter den Handelsnamen FORTRON® - (Kureha, Japan), SUPEC® (General Electric), RYTON® (Phillips Petrol) und TEDUR® (Bayer AG) erhältlichen PAS-haltigen Formmassen.

Leiterplatten-Anwendungen sind erfindungsgemäß alle Formkörper, bei denen die PAS-Formmasse als Trägermaterial für Metalle in der Elektronik und Elektrotechnik eingesetzt wird. Die Leiterplatten können sowohl Platten wie auch Folien (z.B. für Kondensator-Anwendungen) sein. Es können auch PAS-Formteile sein, auf denen makroskopisch dicke Metallformteile haften sollen, die dann aufgrund der elektrischen Eigenschaften des Hybrids PAS/Metall Verwendung finden.

Die PAS-Formmassen werden auf bekannte Weise auf üblichen Verarbeitungsmaschinen zu Formteilen für Leiterplatten verarbeitet. Dabei wird z.B. durch Abspritzen in relativ gering temperierte Werkzeuge oder durch Extrusion mit raschem Abkühlen an der Extrusionsaustrittsstelle eine im wesentlichen amorphe PAS-Formmasse verwendet werden, die von sich aus nur sehr schlecht kristallisieren und daher in der Regel schon eine amorphe Formteil-Deckschicht besitzen. Solche PAS-Formmassen sind z.B. verzweigt oder in ihrer Kristallisation z.B. durch Additive oder durch Störstellen gehindert.

Bevorzugt verwendete PAS-haltige Formmassen haben Glastemperaturen von mehr als 85 °C und eine Wärmeformbeständigkeit (bestimmt nach Vicat B) von mehr als 230 °C, insbesondere von mehr als 260 °C. Bei teilkristallinen PAS mit Glastemperaturen unterhalb 230 °C kann durch Zusatz von Füllstoffen und Kristallisationsbildnern eine Erhöhung der Vicat B Temperatur bis zu 270 °C erreicht werden.

Die mit Metall zu beschichtende Oberfläche wird dann mit aprotischen Lösungsmitteln in Kontakt gebracht, bei Temperaturen von 10 °C bis der Glastemperatur des PAS, bevorzugt von 10 °C bis 80 °C und insbesondere von 20 °C bis 30 °C.

Erfindungsgemäß geeignete aprotische organische Flüssigkeiten sind Lactame, z.B. N-substituierte Lactame wie N-Methylcaprolactam (NMC), N-Methylpyrrolidin (NMP) und 2-Methyltetrahydrofuran. Sie können einzeln oder als Mischung verwendet werden.

Die Kontaktzeiten dieser Flüssigkeiten mit der amorphen Oberfläche der Platte (oder des Films) betragen weniger als 1 Stunde, bevorzugt weniger als 10 Minuten und insbesondere 0,1 bis 60 sec. Es können mehrere Behandlungen auch mit unterschiedlichen organischen Flüssigkeiten durchgeführt werden.

Erfindungsgemäß werden amorphe Oberflächen mit besonders hoher Rauhigkeit erhalten.

Ein weiterer Gegenstand der Erfindung ist die Verwendung der erfindungsgemäß behandelten Platten mit hoher Rauhigkeit der Oberflächen zur Herstellung von Metallbedampften (Leiter)platten.

Bei der erfindungsgemäßen Behandlung der Platte werden nach Trocknen oder Abwischen der Flüssigkeitsreste von den Oberflächen anschließend gegebenenfalls eine Maske nach bekannten Verfahren auf die Oberfläche aufgebracht, die diejenigen Bereiche, die nicht mit Metall in Kontakt kommen sollen, abdecken.

In einer besonderen Variante z.B. kann durch Aufbringen einer Maske auf die Plattenoberfläche kann dafür gesorgt werden, daß nur diejenigen Oberflächenbereiche, die dann mit Metall in Verbindung kommen sollen, mit den aprotischen Flüssigkeiten erfindungsgemäß behandelt werden.

Die Oberfläche der Platte kann nun nach bekannten Verfahren mit Metall in Kontakt gebracht werden, z.B. durch Bedampfen. Katalytische Abscheidung von Metall auf der Oberfläche, Eintauchen in Metallbäder, soweit es die Temperaturbeständigkeit der eingesetzten PAS-Mischung ermöglicht, Sputtern, Plasmabedampfung u.s.w.

Erfindungsgemäß vorbehandelten Platten (Formteile) haben gegenüber Metallen, insbesondere gegenüber Kupfer und Aluminium eine deutlich verbesserte Haftung.

Ein weiterer Vorteil des erfindungsgemäßen Verfahrens ist eine einfache Durchführung, was die Zyklenzeit bei der Plattenherstellung begünstigt. Besondere technische Apparaturen sind nicht erforderlich die Oberflächenbehandlung kann z.B. durch Besprühen oder Eintauchen in die Flüssigkeiten erfolgen.

Ein weiterer Vorteil ist, daß keine anorganischen Flüssigkeiten und Salze nötig sind, (z.B. HF/KF, Methylenchlorid, Aceton). Der Elektrolytgehalt der Platten (Filme) wird durch die erfindungsgemäße Behandlung nicht vergrößert.

Die erfindungsgemäß behandelten Platten eignen sich vorzugsweise zur Herstellung von Leiterplatten.

Beispiele

I) Substanzen:

Verwendet wurden folgende PAS-haltigen Formmassen:
a) Handelsprodukt RYTON P4® (Phillips Petroleum)
b) Handelsprodukt FORTRON 1140 B1® (Kureha)
c) Handelsprodukt CRATON XMB 3100 Natur®, 40 % GF,
d) PAS, hergestellt nach US-A 3 345 129 mit Verzeigerzusatz,
e) PAS, hergestellt nach EP-A 142 024, Beispiel 2 mit Verzweigerzusatz,
f) PAS, hergestellt nach US-A 4 286 018, Beispiel 10, mit Verzweigerzusatz,
g) PAS, hergestellt nach US-A 3 354 129 (lineares PPS).

II) nicht erfindungsgemäße Beispiele:

Beispiel 1 (nicht erfindungsgemäß)

Substanz c) wurde in eine 80 °C heiße Werkzeugform gespritzt, so daß eine amorphe Außenhaut entstand. Anschließend wurde die Oberfläche direkt mit Kupfer nach dem Sputterverfahren bedampft. Die Haftung wurde durch Aufbringen eines Klebestreifens geprüft. Ein Teil der Kupfer-Deckschicht konnte problemlos abgezogen werden.

Beispiel 2 (nicht erfindungsgemäß)

Die PAS-Form aus Beispiel 1 wurde vor Bedampfung mit Kupfer mit a) Wasser, b) Methylenchlorid, c) Aceton für etwa 30 sec. in Kontakt gebracht. Nach Trocknung der Proben bei Raumtemperatur an Luft wurde wie in Beispiel 1 bedampft. Auch hier zeigten sich keine gute Haftungseigenschaften.

III) erfindungsgemäße Beispiele:

Beispiel 3-9 (erfindungsgemäß)

Alle der Substanzen a) bis g) wurden in eine Werkzeugform bei 80 °C abgespritzt. Dann wurden sie jeweils 30 sec. mit
a) NMC
b) NMP
c) 2-Methyl-Tetrahydrofuran

bei 25 °C in Kontakt gebracht, anschließend wurden die Oberflächen nach Trocknung bei Raumtemperatur an Luft mit Kupfer - wie in Beispiel 1 - bedampft.

**Patentansprüche**

1. Verfahren zur Herstellung von Leiterplatten aus Polyarylensulfid-haltigen Formmassen, dadurch gekennzeichnet, daß Leiterplatten aus einer Polyarylensulfid-haltigen Formmasse mit im wesentlichen amorpher Oberfläche mit aprotischen organischen Flüssigkeiten, bei Temperaturen von 10 °C bis der Glastemperatur der verwendeten Polyarylsulfid-Formmasse gegebenenfalls nach Aufbringen eines reversiblen Maskennegativs auf die mit Metall zu kontaktierende Leiterplatten-Oberfläche, behandelt werden und dann durch Bedampfen mit den entsprechenden Metallatomen nach bekannten Verfahren metallisiert wird.

2. Verfahren nach Anspruch 1, dadurch gekennzeichnet, daß mehrere Behandlungen mit der organischen Flüssigkeit durchgeführt werden.

Europäisches Patentamt

# EUROPÄISCHER RECHERCHENBERICHT

Nummer der Anmeldung

**EP 90 12 3538**

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.5) |
|---|---|---|---|
| A,D | EP-A-0 182 379 (PHILLIPS PETROLEUM CO.)<br>* Insgesamt *<br>– – – | 1-2 | H 05 K 3/38<br>C 23 C 14/02 |
| A,D | EP-A-0 103 149 (PHILLIPS PETROLEUM CO.)<br>* Insgesamt *<br>– – – | 1,2 | |
| A | US-A-3 854 973 (M. MERSEREAU et al.)<br>* Insgesamt *<br>– – – – – | 1,2 | |
| | | | **RECHERCHIERTE SACHGEBIETE (Int. Cl.5)** |
| | | | C 23 C<br>H 05 K |

Der vorliegende Recherchenbericht wurde für alle Patentansprüche erstellt

| Recherchenort | Abschlußdatum der Recherche | Prüfer |
|---|---|---|
| Den Haag | 06 Juni 91 | JOFFREAU P.O. |

KATEGORIE DER GENANNTEN DOKUMENTE

X: von besonderer Bedeutung allein betrachtet
Y: von besonderer Bedeutung in Verbindung mit einer anderen Veröffentlichung derselben Kategorie
A: technologischer Hintergrund
O: nichtschriftliche Offenbarung
P: Zwischenliteratur
T: der Erfindung zugrunde liegende Theorien oder Grundsätze

E: älteres Patentdokument, das jedoch erst am oder nach dem Anmeldedatum veröffentlicht worden ist
D: in der Anmeldung angeführtes Dokument
L: aus anderen Gründen angeführtes Dokument

&: Mitglied der gleichen Patentfamilie, übereinstimmendes Dokument